# FASCICULE DE BREVET EUROPEEN

(11) **EP 1 961 115 B1**
(45) Date de publication et mention de la délivrance du brevet: **08.04.2009**
(21) Numéro de dépôt: 06830542.4
(22) Date de dépôt: 12.12.2006
(51) Int. Cl.: H03F 3/45, H03M 3/00

(54) **CIRCUIT ELECTRONIQUE A COMPENSATION DE DECALAGE INTRINSEQUE DE PAIRES DIFFERENTIELLES**
ELEKTRONISCHE SCHALTUNG MIT KOMPENSATION DES INTRINSISCHEN OFFSETS VON DIFFERENZPAAREN
ELECTRONIC CIRCUIT WITH COMPENSATION OF INTRINSIC OFFSET OF DIFFERENTIAL PAIRS

(30) Priorité: 16.12.2005 FR 0512837
(43) Date de publication de la demande: 27.08.2008
(73) Titulaire: E2V Semiconductors, 38120 Saint Egreve (FR)
(72) Inventeur: BORE, François, F-38100 GRENOBLE (FR); BRUEL, Sandrine, F-38000 GRENOBLE (FR)
(74) Mandataire: Guérin, Michel
(86) Numéro de dépôt international: PCT/EP2006/069583
(87) Numéro de publication internationale: WO 2007/068688

(56) Documents cités:
- US-A- 3 434 069
- US-A- 6 114 906
- US-A1- 2001 007 443

## Description

L'invention concerne les circuits électroniques intégrés analogiques utilisant des paires différentielles permettant de convertir une différence de deux tensions d'entrée en une différence de deux courants de sortie.

Dans une paire différentielle, la différence de courants de sortie est une fonction de la différence des tensions d'entrée, et si on applique une différence de potentiel nulle entre les entrées, par exemple en court-circuitant les entrées, la différence des courants de sortie devrait être nulle.

Or les défauts d'appairement des composants qui constituent la paire font que la paire présente une tension de décalage d'entrée, plus communément appelée tension d'offset, non nulle ; cette tension d'offset représente le déséquilibre intrinsèque de la paire et se traduit par une différence de courants de sortie non nulle en présence d'une tension différentielle d'entrée nulle. En pratique, la tension d'offset est la tension de compensation qu'il faut appliquer entre les entrées pour que la différence de courants de sortie soit nulle.

Une paire différentielle comporte classiquement deux branches alimentées par une même source de courant de référence Io, chaque branche comportant un transistor et une charge. Les tensions d'entrée sont appliquées aux bases des transistors, les émetteurs sont reliés à la source de courant commune, et les collecteurs sont reliés aux charges. Le courant de la source se partage entre les deux branches en fonction de la différence de tensions d'entrée appliquées aux bases.

Les paires différentielles peuvent être utilisées individuellement ou regroupées en associations de paires lorsque les montages sont plus complexes. Par exemple, deux paires peuvent partager une même charge, le collecteur d'un transistor d'une paire étant relié au collecteur d'un transistor d'une autre paire. Les paires peuvent être montées en cascade, une sortie en courant d'une paire étant reliée à une sortie en courant d'une autre paire qui elle-même a une autre sortie en courant reliée à une troisième paire, et ainsi de suite. Selon l'utilisation des paires différentielles, on peut trouver différentes associations de paires. L'invention s'applique de manière générale à toutes ces utilisations

De telles paires différentielles sont utilisées notamment dans des convertisseurs analogiques-numériques. Elles servent par exemple pour la constitution de comparateurs, chaque comparateur comprenant une paire différentielle recevant en entrée d'une part une tension à convertir, d'autre part une tension de référence ; elles servent aussi, toujours pour des convertisseurs, dans des circuits de repliement , un circuit de repliement comprend plusieurs cellules de repliement chacune constituée d'au moins une paire différentielle, les sorties en courant des cellules étant reliées en cascade les unes aux autres pour établir une tension ou un courant analogique de sortie qui varie en cloche ou en sinusoïde en fonction de la tension d'entrée à convertir ; les différentes cellules reçoivent chacune la tension d'entrée et une tension de référence respective.

Dans les circuits analogiques de précision utilisant plusieurs paires différentielles, on se rend compte que des imprécisions de fonctionnement (notamment des imprécisions de conversion dans les convertisseurs) peuvent résulter de la présence de tensions d'offset non nulles ; d'un point de vue physique, ces tensions d'offset résultent surtout du fait que les tensions émetteur-base des différents transistors des paires ne sont pas exactement identiques même lorsqu'ils sont parcourus par des courants identiques.

En effet, les technologies ne sont pas parfaites et deux transistors fabriqués simultanément, ayant au moins théoriquement les mêmes surfaces d'émetteur, et même placés côte à côte dans un circuit intégré donc ayant toutes les chances d'être identiques, n'ont pas des caractéristiques rigoureusement identiques. Ceci résulte d'une dispersion de fabrication inévitable. De plus, non seulement les deux transistors d'une paire engendrent une tension d'offset dans cette paire, mais, du fait même de cette dispersion, les différentes paires différentielles d'un circuit intégré présentent inévitablement des tensions d'offset différentes les unes des autres.

On a déjà proposé de réduire cet inconvénient en utilisant des paires différentielles ayant des transistors plus gros. Ils présentent moins de dispersion car on maîtrise mieux leur taille. Mais alors, les capacités sont plus grandes et les circuits sont donc plus lents, ce qui n'est pas souhaitable dans des applications telles que les convertisseurs analogiques-numériques rapides. Pour ces derniers, il vaudrait mieux avoir de plus petits transistors dans les paires différentielles. De plus, les circuits sont plus encombrants si les transistors sont plus gros, et ils consomment plus de courant.

On a proposé également des solutions de calibration individuelle a posteriori : un convertisseur fabriqué est testé et les erreurs de conversion sont stockées dans une mémoire EPROM du circuit intégré pour servir à la compensation des erreurs lors de l'utilisation. Des solutions d'ajustage par laser existent également, notamment pour ajuster individuellement les résistances présentes dans les branches différentielles. Cette technique exige un test individuel et une correction individuelle de chaque circuit-intégré en fonction des erreurs de conversion constatées. La méthode est donc très coûteuse industriellement, chaque circuit devant être testé et corrigé individuellement.

Le document US2003 009620A1 montre un procédé et un circuit correspondant de correction automatique de tension d'offset d'un circuit intégré differentiel selon le préambule de la revendication 1.

L'invention vise à proposer une solution réduisant ces inconvénients pour offrir un meilleur compromis entre la qualité, le coût du circuit et sa consommation.

L'invention propose d'incorporer au circuit qui comprend une paire différentielle ou un groupe de paires associées un circuit de calibration automatique associé à cette paire ou à ce groupe de paires ; ce circuit examine, pendant une phase de calibration automatique distincte de la phase d'utilisation normale, la valeur du courant de sortie différentiel produit par la paire en présence d'une tension différentielle d'entrée nulle ; il compare cette valeur à au moins un seuil, et, en fonction du résultat, il garde en mémoire et applique ou non une correction à l'entrée de la paire pendant la phase d'utilisation normale de celle-ci. La correction est appliquée à un étage suiveur placé en amont d'une entrée de la paire différentielle, de la manière suivante : la correction est appliquée à une source de courant qui traverse un transistor de l'étage suiveur ; la tension base-émetteur va varier en fonction de ce courant, et cette variation est reportée à l'entrée de la paire différentielle dont l'offset est ainsi corrigé partiellement ou totalement.

La mesure du courant différentiel qui résulte de l'application d'une tension différentielle nulle à l'entrée est de préférence faite par application d'impulsions de courants de charge et décharge successifs à une capacité pendant une série de créneaux au cours de la phase de calibration. Le courant de charge est le courant d'une des branches de la paire différentielle, le courant de décharge est le courant de l'autre branche. Au bout de n impulsions, la capacité est chargée en proportion de la différence de courant entre les branches. Il y a de préférence deux capacités symétriques pour des raisons de construction technologique des capacités.

En résumé, le procédé de correction automatique d'offset selon l'invention, appliqué à un circuit intégré différentiel comportant au moins une paire différentielle avec en amont au moins un étage suiveur ayant un transistor et une source de courant, comporte les étapes suivantes :
- annuler les tensions différentielles sur les entrées du circuit différentiel pendant une phase de calibration distincte de la phase d'utilisation normale,
- charger une capacité par la différence des courants de sortie des branches de la paire différentielle dans cette phase,
- comparer la tension aux bornes de la capacité à au moins un seuil,
- garder en mémoire, pendant la phase d'utilisation normale suivant la phase de calibration, le résultat de la comparaison,
- appliquer à la source de courant (SC1) en phase d'utilisation normale une correction fonction du résultat gardé en mémoire.
   Le circuit intégré électronique à paires différentielles selon l'invention comporte donc au moins deux entrées pour recevoir deux tensions, deux sorties en courant appliquées à des charges, et au moins une paire de branches différentielles reliées à ces charges et, en amont de la paire différentielle, au moins un étage suiveur comportant un transistor et une source de courant reliée à l'émetteur de ce transistor ; le circuit intégré est caractérisé en ce qu'il comporte
- un séquenceur pour établir une phase de calibration de tension de décalage et une phase d'utilisation du circuit après calibration,
- au moins une capacité associée à la paire différentielle,
- un ensemble de commutateurs actionnés par le séquenceur pour aiguiller les courants de sortie vers les charges pendant la phase d'utilisation et pour d'une part appliquer une tension différentielle nulle sur les entrées et d'autre part aiguiller alternativement l'un puis l'autre des courants de sortie vers la capacité pendant la phase de calibration, en alternant charge et décharge, pendant une série de créneaux fournis par le séquenceur,
- un circuit de détection de seuils de tension aux bornes de la capacité, actionné par le séquenceur à la fin de la série de créneaux, ce circuit fournissant un signal d'état représentant le dépassement ou non dépassement d'un seuil et le signe de la tension aux bornes des capacités,
- un circuit de maintien du signal d'état en sortie du circuit de détection, pour maintenir pendant la phase d'utilisation une valeur d'état qui a été déterminée pendant la phase de calibration,
- un circuit de modification du courant de la source de courant de l'étage suiveur en fonction de la valeur d'état présente en sortie du circuit de maintien.

S'il y a deux capacités au lieu d'une, le circuit comprend des commutateurs pour charger pendant une alternance l'une des capacités par l'un des courants de sortie de la paire différentielle pendant que l'autre est déchargée par l'autre courant de sortie, après quoi, pendant l'alternance suivante, c'est la première capacité qui est déchargée par le courant de la deuxième sortie pendant que la deuxième capacité est chargée par le courant de la première sortie. Les capacités sont ensuite mises en série pour additionner leurs charges et comparer la somme au seuil.

On peut prévoir qu'il y a plusieurs seuils, pour déterminer plusieurs corrections possibles, ou alternativement qu'il y a deux cycles successifs (ou plus), un premier cycle établissant une première correction de courant sur l'étage suiveur et un deuxième cycle établissant une correction supplémentaire, sans supprimer la première correction.

L'invention est tout particulièrement applicable à des paires différentielles plus sophistiquées qu'une simple paire différentielle à deux transistors, et notamment à des paires imbriquées comportant quatre branches différentielles partageant deux à deux une charge commune. En particulier, l'invention est applicable à un convertisseur analogique-numérique qui comprend un étage de repliement de signal comprenant plusieurs cellules de repliement elles-mêmes constituées à partir de paires différentielles imbriquées à quatre branches.

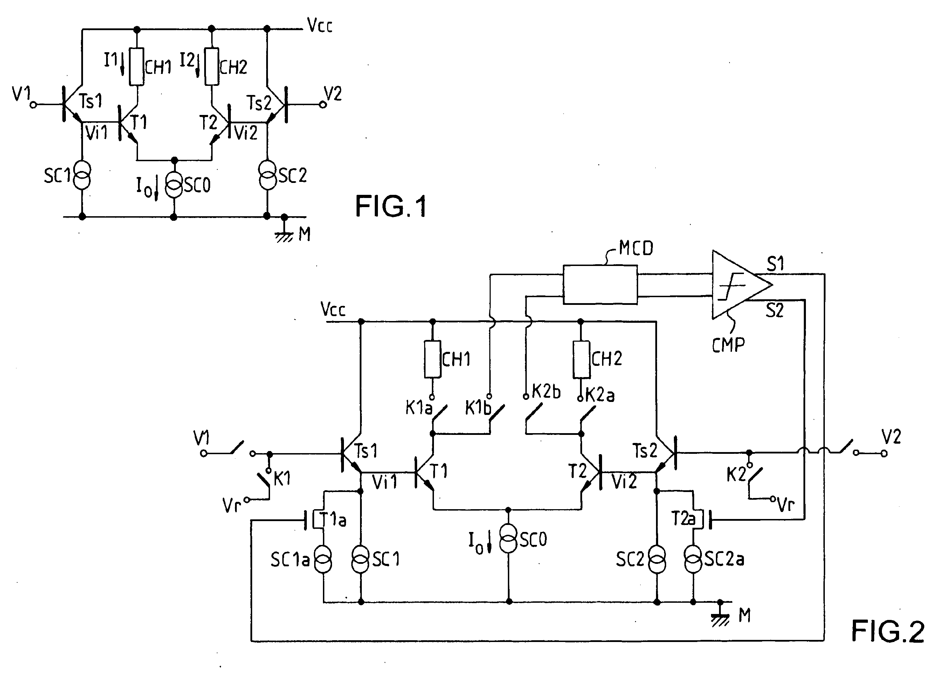

D'autres caractéristiques et avantages de l'invention apparaîtront à la lecture de la description détaillée qui suit et qui est faite en référence aux dessins annexés dans lesquels :
- la figure 1 représente une paire différentielle avec des étages suiveurs en amont des entrées ;
- la figure 2 représente le schéma de l'invention appliqué à la paire de la figure 1 ;
- la figure 3 représente le circuit de mesure de courant différentiel et le détecteur de seuil associé ;
- la figure 4 représente une constitution classique de cellule de repliement de signal comportant une paire différentielle imbriquée à quatre branches différentielles ;
- la figure 5 représente l'application du principe de l'invention à la cellule de la figure 4.
   On va d'abord expliquer le principe général de l'invention à propos d'une paire différentielle simple, avant de montrer comment on peut l'appliquer à un groupe de paires différentielles associées, notamment un groupe de deux paires différentielles imbriquées qui font partie d'une cellule de repliement de signal destinée à un convertisseur analogique-numérique.
   Le schéma de la figure 1 rappelle le principe d'une paire différentielle simple qui comporte, en amont de chaque entrée de la paire proprement dite, un étage suiveur de tension qui commande cette entrée. De tels montages avec étage suiveur sont très classiques, l'étage suiveur ayant notamment pour rôle d'amener à un niveau de mode commun désiré les tensions d'entrée appliquées à la paire.
   La paire proprement dite comporte deux branches ; chaque branche comprend un transistor, T1 pour la première branche, T2 pour la deuxième branche, et une charge CH1, CH2 respective. L'entrée de la paire est constituée par les bases des transistors T1 et T2 ; les sorties sont constituées par les courants 11, 12 dans les charges. Les émetteurs des transistors sont reliés à une source de courant constant SC0 fournissant un courant Io. La tension sur la base de T1 est Vi1 la tension sur la base de T2 est Vi2. L'ensemble est connecté entre une masse M et une tension d'alimentation Vcc.
   En amont des bases des transistors se trouvent les étages suiveurs. L'étage suiveur qui contrôle la tension Vi1 comprend, dans une configuration simple donnée à titre d'exemple, un transistor suiveur Ts1, et une source de courant constant SC1 reliée entre l'émetteur de Ts1 et la masse ; le collecteur de Ts1 est relié à Vcc. De même, l'étage suiveur qui contrôle la base du transistor T2 de l'autre branche différentielle comprend un transistor suiveur Ts2 et une source de courant SC2, connectées exactement comme le premier étage suiveur. Les tensions d'entrée de l'ensemble du circuit différentiel (paire différentielle et étages suiveurs) sont des tensions V1 et V2 appliquées aux bases des transistors suiveurs Ts1 et Ts2. Les émetteurs de ces transistors sont reliés aux bases des transistors T1 et T2 de la paire différentielle. La différence entre la tension d'entrée V1 du circuit et la tension d'entrée Vi1 de la paire est la chute de tension base-émetteur du transistor suiveur TS1. Elle est déterminée par le courant de la source SC1. Il en est de même pour la chute de tension V2-Vi2. Les transistors T1 et T2 sont identiques ; les transistors Ts1 et Ts2 sont identiques ; les sources de courant SC1 et SC2 sont identiques. Seules les dispersions technologiques affectent cette identité.
   La figure 2 représente le schéma de principe de la correction automatique d'offset proposée ici.
   La correction utilise un circuit de calibration automatique qui est activé pendant une phase de calibration, distincte de la phase d'utilisation normale. Par exemple la phase de calibration est exécutée automatiquement à chaque mise sous tension du circuit. Un séquenceur non représenté produit les signaux logiques nécessaires au déroulement de cette phase. Ces signaux logiques commandent notamment des interrupteurs visibles sur la figure 2.
   Tout d'abord, le circuit de calibration comporte des interrupteurs qui court-circuitent les entrées du circuit différentiel pendant la phase de calibration. Par exemple, il y a un interrupteur K1 reliant la base de Ts1 à une référence de tension fixe Vr et un interrupteur K2 reliant la base de Ts2 à la même référence de tension Vr, ce qui est une manière de court-circuiter les entrées. Pendant ce temps, les bases des transistors Ts1 et Ts2 sont isolées des entrées normales du circuit différentiel.
   Puis, il y a un interrupteur K1 a et un interrupteur K2a qui isolent le collecteur de T1 ou T2 de la charge respective CH1, CH2 pendant la phase de calibration, et un interrupteur K1b et un interrupteur K2b qui relient ces collecteurs chacun à une entrée d'un circuit de mesure de courant différentiel MCD sur le détail duquel on reviendra plus loin. Ce circuit produit une valeur de tension représentative de la valeur signée du courant différentiel présent lorsque la tension différentielle d'entrée est nulle. La sortie du circuit de mesure de courant MCD est appliquée à un circuit de comparaison CMP.
   Le circuit de comparaison CMP possède deux sorties S1 et S2 ; les tensions sur ces sorties sont des signaux d'état représentant une valeur de correction d'offset à appliquer à la paire différentielle pour diminuer ou annuler sa tension d'offset. Dans la version la plus simple, mais suffisante dans certains cas, les sorties sont des sorties binaires n'ayant que deux états possibles et le circuit de comparaison est un comparateur à seuil ; aucune correction n'est appliquée si le seuil n'est pas dépassé ; une seule valeur de correction est appliquée si le seuil est dépassé, soit par la sortie S1 soit par la sortie S2 selon le signe de la tension produite à la sortie du circuit de mesure de courant MCD.
   Dans des versions plus sophistiquées, on pourrait prévoir que le circuit de comparaison comporte un plus grand nombre de sorties pour appliquer une correction plus précise en fonction du dépassement de plusieurs seuils. Cela sera nécessaire par exemple pour des convertisseurs de haute résolution (12 bits par exemple).
   Une correction par une seule valeur peut suffire si l'offset à corriger est faible par nature et si la précision du convertisseur est limitée (convertisseur 8 bits par exemple). Le schéma de la figure 2 correspond à ce cas : la sortie S1 est binaire, elle reste à zéro si le courant différentiel mesuré reste inférieur au seuil, et elle passe à 1 si le seuil est dépassé. De même pour S2 mais pour un signe de courant différentiel opposé, donc un signe de tension d'offset opposé.
   La sortie S1 commande l'un des étages suiveurs, et la sortie S2 commande l'autre. Cette commande comprend l'ajout d'un courant constant supplémentaire en parallèle avec le courant de la source SC1 ou SC2. Le courant constant est celui d'une source auxiliaire de faible valeur SC1 a (ou respectivement SC2a). La sortie S1 commande donc la mise en conduction ou le blocage d'un transistor T1 a en série avec la source SC1 a. L'ensemble de la source SC1 a et du transistor T1 a est placé en parallèle sur la source principale SC1 de l'étage suiveur. La source SC1 est en général constituée par un transistor en série avec une résistance. L'ensemble SC1a+T1a peut être placé en parallèle sur la résistance (de préférence) ou sur l'ensemble de la source SC1. Le montage pour l'autre étage suiveur est le même, avec une source auxiliaire SC2a et un transistor de commande T2a.
   Le comparateur CMP est constitué de manière à garder en mémoire après la phase de calibration l'état pris par les sorties S1 et S2 pendant la phase de calibration. Un circuit de maintien est donc prévu dans le comparateur ou intercalé entre le comparateur et les transistors T1 a et T1b.
   La correction de l'offset résulte de la modification de la chute de tension base-émetteur du transistor suiveur Ts1 ou Ts2, qui elle-même résulte du passage d'un plus grand courant d'émetteur dans le transistor. Si le courant différentiel mesuré pendant la phase de calibration dépasse le seuil acceptable, alors une chute de tension supplémentaire sur le transistor suiveur Ts1 ou Ts2 est appliquée pendant les phases d'utilisation et elle compense l'offset qui existe naturellement dans la paire.
   On notera que l'offset global de la paire peut résulter des défauts d'appairement des transistors T1 et T2, ou des transistors Ts1 et Ts2, ou de leurs sources de courant.

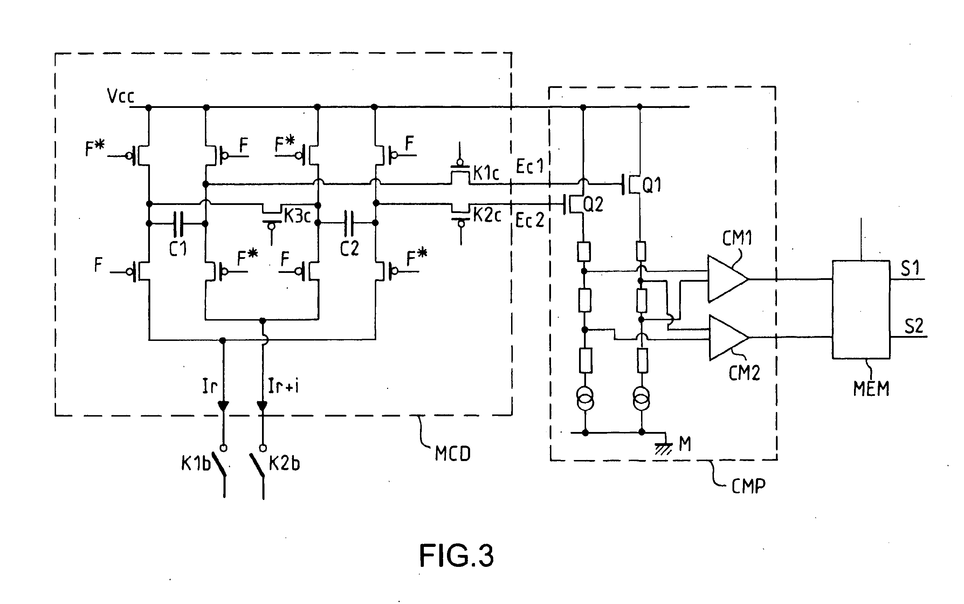

   La figure 3 représente la constitution de l'ensemble du circuit de mesure de courant différentiel MCD et du circuit de comparaison CMP.
   On a représenté sur la figure 3 les interrupteurs K1 b et K2b par lesquels les courants de sortie de la paire différentielle peuvent être amenés au circuit MCD pendant la phase de calibration. Ces courants seraient en principe égaux s'il n'y avait pas d'offset. En présence d'un offset, on considère qu'il y a un courant Ir sur la sortie de la première branche différentielle et un courant Ir+i sur la deuxième, avec Ir= (Io-i))/2, le courant i étant le courant différentiel qui résulte de l'offset et qu'on va mesurer.
   Le circuit MCD comporte deux capacités C1 et C2 dans lesquelles on va progressivement intégrer le courant i pendant la phase de calibration. On notera qu'il n'est pas obligatoire d'avoir deux capacités une seule suffirait, mais la technologie des capacités est telle qu'il est préférable d'en avoir deux et de décharger l'une pendant qu'on charge l'autre pour éviter une dissymétrie induite par la technologie de fabrication des capacités (typiquement, l'armature inférieure de la capacité présente une capacité parasite par rapport au substrat, non négligeable, contrairement à l'armature supérieure).
   La première capacité C1 est associée à quatre commutateurs qui sont représentés par des transistors MOS. La capacité C2 est associée à quatre autres commutateurs. Ces commutateurs sont actionnés en alternance par deux signaux d'horloge F et F* complémentaires et de même durée T, et ceci pendant n périodes d'horloge successives. Pendant un créneau F, certains commutateurs sont ouverts et d'autres fermés ; pendant le créneau suivant F* c'est le contraire. Les commutateurs fermés pendant le créneau F font circuler un courant qu'on peut appeler courant de charge Ir+i en provenance de l'interrupteur K2b (deuxième branche différentielle de la paire) dans la capacité C2, et un courant qu'on appellera courant de charge Ir en provenance de l'interrupteur K1b (première branche) dans la capacité C1. Pendant le créneau suivant F*, les commutateurs sont inversés et font circuler un courant de décharge Ir (issu de la première branche) dans la capacité C2 et un courant de décharge Ir+i (deuxième branche) dans la capacité C1.
   Les capacités C1 et C2 prennent une charge (Ir+i).T et -Ir.T respectivement si T est la durée du créneau F. La durée T est choisie suffisamment faible pour que la tension aux bornes des capacités ne se rapproche pas de valeurs qui satureraient les transistors qui amènent les courants. Pendant le créneau suivant F*, la capacité C2 perd une charge Ir.T et la capacité C1 gagne une charge (Ir+i).T
   A la fin d'une paire de créneaux F, F* consécutifs, les capacités C1 et C2 ont chacune une charge i.T avec des signes opposés.
   Les capacités C1 et C2 sont en principe égales à une valeur commune C. On notera que l'appariement de deux capacités peut être bien meilleur (d'un facteur 4 à 10) que l'appariement de résistances ou de transistors dans le même procédé de fabrication.
   Au bout de n périodes de charges et décharges alternées F et F*, la charge dans les capacités est n.i.T. Le nombre n de paires d'alternances est choisi suffisamment grand (T étant petit) pour que la tension n.i.T/C aux bornes des capacités soit largement plus grande que la tension d'offset qui a donné lieu à cette mesure et que la tension d'offset du circuit de comparaison, et pour qu'elle soit facilement comparable à un seuil dans le circuit de comparaison CMP. Le produit n.T doit être limité pour ne pas saturer les interrupteurs par la tension n.i.T. La durée T peut être d'environ 2 nanosecondes, la capacité d'environ 1 picofarad, et le nombre n d'environ 20, pour obtenir une tension de charge d'environ 100 mV pour un écart de courant de 2,5 microampères. Une tension de 100 millivolt peut facilement être comparée à un seuil.
   Après les n créneaux F et F*, le séquenceur place les deux capacités en série pour fournir une tension qui est le double de la tension aux bornes de chaque capacité, et cette tension est appliquée au circuit de comparaison CMP. Trois interrupteurs K1 c, K2c et K3c sont rendus passants pour servir d'une part à cette mise en série et d'autre part à la connexion de la tension somme entre les entrées du circuit CMP.
   Dans cet exemple, le circuit CMP comprend deux étages suiveurs à grande impédance d'entrée qui comportent deux transistors MOS Q1 et Q2 (entrées Ec1 et Ec2 sur les grilles) avec un pont de résistances respectif qui est connecté à la source de chacun de ces transistors et qui est alimenté par une source de courant. Les tensions appliquées aux grilles des transistors sont reportées sur les sources et définissent les tensions d'alimentation des ponts de résistance. Deux points intermédiaires de ces ponts sont connectés à deux comparateurs CM1, CM2, selon un montage tel que
- les comparateurs sont tous deux dans un premier état si l'écart de tension entre leurs bornes est inférieur à un seuil,
- le comparateur CM1 bascule si l'écart de tension, dans un premier sens, excède un seuil,
- le comparateur CM2 bascule si l'écart de tension, dans un sens opposé, excède le même seuil ; par construction, seul le comparateur concerné par le dépassement du seuil peut basculer.

Une bascule mémoire MEM, connectée aux sorties des comparateurs CM1 et CM2, est actionnée par le séquenceur après que les comparateurs ont joué leur rôle, et elle conserve en mémoire, après la fin de la phase de calibration, l'état de sortie des comparateurs ; elle fournit sur ses propres sorties S1 et S2 les valeurs logiques représentant cet état. Les sorties S1 et S2 contrôlent les sources de courant auxiliaires SC1 a, SC2a comme expliqué en référence à la figure 2.

On comprendra qu'une comparaison plus sophistiquée pourrait être faite, un jeu de comparateurs fournissant un plus grand nombre de sorties pour contrôler un plus grand nombre de sources de courant auxiliaires, égales entre elles ou pondérées entre elles (en binaire par exemple) sur chaque étage suiveur en amont des entrées de la paire différentielle.

Egalement, on comprendra qu'on pourrait envisager, toujours avec un plus grand nombre de sources de courant additionnelles sur chaque étage suiveur, que la phase de calibration s'effectue en plusieurs temps même avec seulement les deux comparateurs de la figure 3, à la condition toutefois que la mémoire MEM ait plusieurs couples de sorties S1a, S2a S1 b, S2b, etc. pour stocker les valeurs d'état prises par les comparateurs au cours de chaque cycle et pour commander des sources de courant auxiliaires en plus grand nombre. Le séquenceur de la phase de calibration est alors programmé pour exécuter deux cycles successifs ou plus s'il y a plus de deux sources de courant auxiliaires par étage suiveur :
- cycle A : on fait une mesure à la fin d'une première série de n paires de créneaux F et F* ; on aboutit à un premier état des comparateurs, stocké dans la mémoire sous forme de valeurs S1a et S2a. La mémoire conserve ces valeurs pendant le reste de la phase de calibration (en particulier pendant le deuxième cycle B) et ultérieurement pendant la phase d'utilisation normale du circuit différentiel ; les valeurs S1a et S2a contrôlent pendant tout ce temps les sources de courant auxiliaires SC1 a et SC2a ;
- cycle B : on fait une deuxième mesure à la fin d'une deuxième série de paires de créneaux F et F* ; on aboutit à un nouvel état des comparateurs qui peut être différent du premier état puisque cette nouvelle mesure est faite alors que l'une des sources auxiliaires SC1a ou SC2a est peut-être connectée ; l'état des sorties est stocké sous forme de valeurs S1 b, S2b dans la mémoire MEM sans perdre le contenu des valeurs S1 a, S2a. Les valeurs mémorisées S1b; S2b contrôlent des sources de courant auxiliaires supplémentaires SC1 b, SC2b en parallèle avec les sources auxiliaires SC1 a et SC2a, et la correction des deuxièmes sources s'ajoute à la correction des premières. Une pondération, par exemple binaire, peut être faite entre les deux cycles, par exemple en donnant aux sources auxiliaires SC1 b SC2b une valeur de courant moitié de celle des sources SC1a, SC2a et en doublant le nombre n de périodes d'horloge au cours du deuxième cycle pour pouvoir continuer à utiliser les mêmes seuils dans le comparateur.
   On va maintenant décrire une application particulière à une association de deux paires différentielles, cette association constituant une cellule de repliement d'un circuit de repliement d'un convertisseur analogique-numérique. Le circuit de repliement comporte plusieurs cellules mises en cascade les unes avec les autres. Chaque cellule comporte deux entrées pour recevoir une tension différentielle Vin-Vip à convertir, sous forme de deux tensions Vin, Vip (la même tension Vin, Vip pour toutes les cellules), et deux entrées pour recevoir une tension différentielle de référence Vrefn-Vrefp sous forme de deux tensions de référence Vrefn et Vrefp (tensions de référence différentes pour chaque cellule du circuit de repliement).

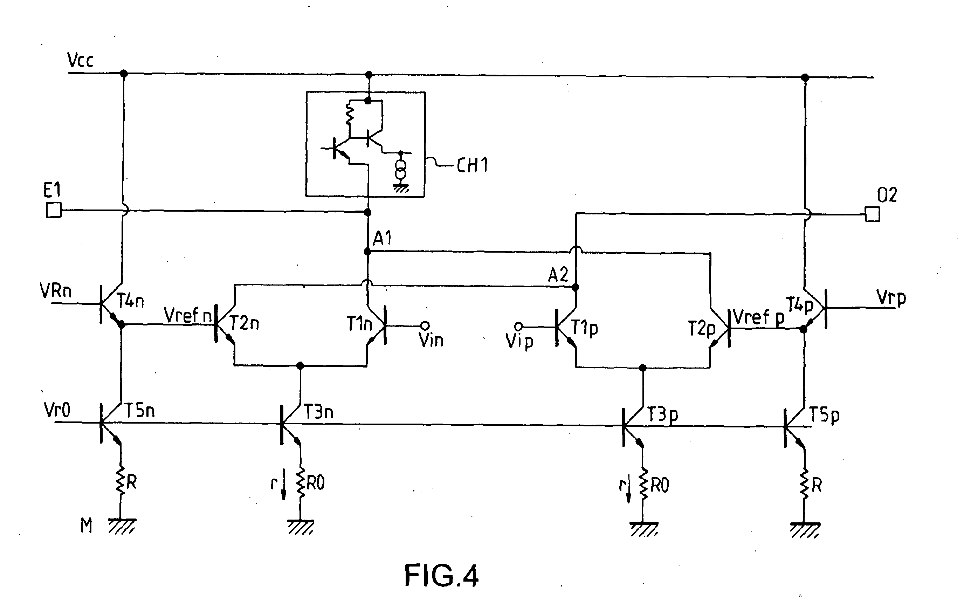

   La figure 4 représente une cellule élémentaire de repliement, qui ne comporte pas le perfectionnement selon l'invention. Elle comprend une première paire différentielle (transistors T1n, T2n) recevant respectivement comme entrées Vin et Vrefn et une deuxième paire (transistors T1p et T2p) recevant comme entrées Vip et Vrefp.
   Une charge CH1 sert de charge commune à la branche T1 n de la première paire, à la branche T2p de la deuxième paire, et également à deux branches d'une cellule précédente non représentée (connexion de cette cellule précédente par une borne E1 de la cellule représentée, E1 étant reliée à la charge CH1). Une charge non représentée, car elle fait partie de la cellule suivante, est connectée à une borne 02 de la cellule ; elle sert de charge commune pour la branche T2n de la première paire, pour la branche T1 p de la deuxième paire, et pour deux branches de la cellule suivante.
   La charge peut être classiquement constituée par un transistor cascode et un transistor suiveur.
   Les sources de courant qui alimentent les deux transistors de chaque paire (l'équivalent des sources SC0 de la figure 1) ont été représentées ici sous forme de transistors avec résistance d'émetteur, qui correspond à une réalisation pratique classique : transistor T3n pour la première paire et résistance de valeur R0, transistor identique T3p et résistance de même valeur R0 pour la deuxième paire.
   On a représenté également un étage suiveur en amont de la base du transistor T2n (entrée Vrefn) et un étage équivalent en amont de la base du transistor T2p (entrée Vrefp) ; on n'a pas représenté d'étage suiveur en amont des bases qui reçoivent Vin et Vip, bien que de tels étages soient en général prévus (ces étages sont communs à toutes les cellules du circuit de repliement qui reçoivent les mêmes tensions Vin et Vip). L'étage suiveur en amont de la première paire différentielle comprend un transistor suiveur T4n et une source de courant (transistor T5n et résistance d'émetteur de valeur R). L'étage suiveur en amont de la deuxième paire comprend un transistor suiveur T4p avec source de courant constituée par un transistor T5p et une résistance d'émetteur de même valeur R.
   Les entrées du circuit différentiel ainsi constitué sont donc d'une part les tensions Vin et Vip (ou des entrées d'étage suiveur en amont de ces tensions) et d'autre part les tensions VRn et VRp sur les bases des transistors suiveurs T4n et T4p ; les tensions d'entrée VRn et VRp sont reportées, avec une chute de tension base-émetteur, sur les émetteurs des transistors T4n et T4p, émetteurs qui sont reliés aux bases de T2n et T2p respectivement.
   Une tension constante Vr0 commande les bases de tous les transistors qui servent de sources de courant : T3n, T3p, T5n, T5p.
   La réalisation ainsi décrite est la plus simple possible ; des réalisations plus complexes peuvent être prévues, sans que cela modifie ce qui va être dit sur l'utilisation de l'invention dans de telles cellules. Pour plus de détails sur la constitution des cellules, on se reportera aux documents qui traitent classiquement des convertisseurs analogiques-numériques à circuits de repliement.

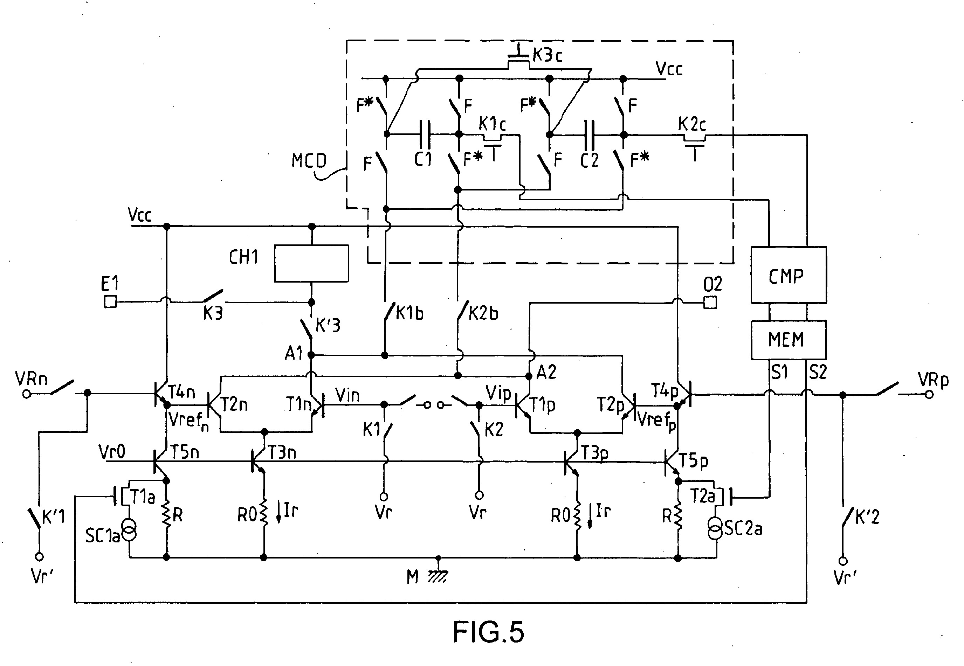

   La figure 5 montre comment la cellule de la figure 4 peut être modifiée pour incorporer de manière avantageuse les principes de la présente invention, en corrigeant l'offset global présenté par le groupe de deux paires différentielles imbriquées (partageant les mêmes charges sur leurs collecteurs), plutôt que l'offset individuel de chaque paire. On va voir comment on va mesurer maintenant, en vue de la correction d'offset, la différence des deux courants de sortie de la cellule, chaque courant de sortie étant ici la somme de deux courants de sortie prélevés dans deux paires respectivement.
   Quatre interrupteurs K1 et K2, K'1 et K'2 permettent de relier à deux références de tension Vr et Vr' respectives, pendant la phase de calibration, les entrées du circuit différentiel de manière que la tension différentielle vue entre les bases de T1p et T2p d'une part et entre T1n et T2n d'autre part soit nulle. Dans le cas où des étages suiveurs individuels précèdent les entrées Vin et Vip, il faut placer les interrupteurs sur les bases de ces suiveurs et dans ce cas les tensions Vr et Vr' peuvent être identiques (en supposant que les suiveurs sont identiques à ceux qui précèdent Vrefn et Vrefp). Cela revient à court-circuiter entre elles toutes les entrées de la paire imbriquée pendant la phase de calibration et en tous cas à appliquer des tensions différentielles nulles sur les paires d'entrée de la paire différentielle imbriquée.
   Un ensemble de deux interrupteurs K3 et K'3, ouverts pendant la phase de calibration, fermés le reste du temps, permet de
- déconnecter la cellule de la cellule précédente pendant cette phase de calibration,
- déconnecter la charge CH1 des collecteurs des paires différentielles.

Sur la figure 5, par exemple, K3 est relié entre la borne E1 et la charge CH1, et l'interrupteur K'3 est relié entre la charge CH1 et le point A1 qui réunit les collecteurs de T1 n et T2p.

Un interrupteur K1 b relie le point de jonction A1 à une première entrée du circuit de mesure de courant différentiel MCD. Un autre interrupteur K2b relie une deuxième entrée de ce circuit MCD au point de jonction A2 qui réunit les collecteurs des transistors T1 p et T2n,

Les interrupteurs K1 b, K2b, K1 et K2, K'1 et K'2 sont fermés pendant la phase de calibration, ouverts le reste du temps.

Le circuit de mesure de courant MCD, dont les entrées sont connectées aux interrupteurs K1b et K2b, peut être rigoureusement identique à celui de la figure 3, avec deux capacités C1 et C2 identiques, des commutateurs pour aiguiller des courants dans les capacités alternativement en provenance de l'interrupteur K1 b puis de l'interrupteur K2b, de manière à accumuler dans les capacités, au cours de n paires de créneaux F et F*, une tension proportionnelle à la différence de courants circulant dans les deux interrupteurs K1b et K2b, différence qui devrait être nulle en l'absence d'offset dans les paires différentielles.

Les commutateurs K1c, K2c, K3c qui permettent de relier les capacités C1 et C2 au circuit de comparaison CMP sont identiques à ceux de la figure 3. Le circuit de comparaison CMP peut être le même et a été représenté sous forme d'un rectangle. La mémoire MEM en sortie du circuit de comparaison fournit deux sorties S1 et S2 qui contrôlent les sources de courant auxiliaires qu'on rajoute en parallèle avec les sources de courant T5n, R et T5p, R des étages suiveurs associés aux entrées de référence VRn, VRp.

Les sources auxiliaires SC1a et SC2a sont commandées par des transistors T1a et T2a, comme à la figure 2, et l'ensemble en série de SC1a et T1a (ou symétriquement SC2a et T2a) est en parallèle sur la résistance d'émetteur R du transistor suiveur respectif.

Les sources de courant auxiliaires peuvent être réalisées par un transistor MOS ayant sa base commandée par une tension constante, ce transistor MOS étant de dimension choisie en fonction du courant auxiliaire désiré pour effectuer la correction.

La source de courant auxiliaire peut être simplement une résistance si elle est en parallèle sur la résistance R. On comprendra que cette disposition augmente le courant de la source de courant principale, ce qui est l'équivalent de la mise en parallèle d'une source de courant auxiliaire avec la source de courant principale. Cependant, il est préférable que la source auxiliaire soit constituée de la même manière que la source principale pour avoir la même variation en fonction de la température.

Le choix de la valeur de courant auxiliaire est en pratique dicté par la technologie : pour une technologie donnée (et des dimensions de transistors de paires différentielles données), on connaît la dispersion attendue des tensions d'offset, et on peut estimer quel est l'incrément de tension d'offset qui permet de limiter cette dispersion à une valeur plus étroite. Cet incrément de tension de décalage permet, connaissant la taille du transistor de l'étage suiveur, de déterminer quel est l'incrément de courant auxiliaire qu'il faut prévoir pour compenser au moins partiellement une tension d'offset qui serait trop forte.

On comprendra que dans une cellule de repliement où les deux paires différentielles sont étroitement mêlées, les courants de sortie qu'il faut considérer pour mesurer un courant différentiel dû à un offset ne sont pas les courants individuels des deux branches d'une paire, mais les courants de sortie du groupe de deux paires différentielles imbriquées, c'est-à-dire des sommes de courants des branches des deux paires. Il serait possible cependant de prévoir des interrupteurs supplémentaires qui séparent les deux paires imbriquées, pour corriger chaque paire individuellement, à condition de prévoir un circuit de mesure séparé pour chaque paire et des étages suiveurs avec sources de courant auxiliaires sur les deux entrées de chaque paire.

Cette correction n'aurait d'intérêt que si des suiveurs individuels précédaient Vip et Vin. Les collecteurs de T1p et T2n d'une part, T1n et T2p d'autre part, étant reliés en marche normale, une autocalibration conservant ces liaisons et considérant l'ensemble des quatre transistors comme une seule paire différentielle est suffisante et la compensation peut se faire uniquement sur une entrée Vrefn ou Vrefp selon le sens de l'offset.

La description qui précède fait apparaître des paires différentielles à transistors bipolaires, mais l'invention est applicable si les transistors sont des transistors à effet de champ et on considérera que les appellations base, émetteur et collecteur recouvrent aussi les électrodes équivalentes de grille source et drain de transistors à effet de champ.

## Revendications

1. Procédé de correction automatique de tension d'offset d'un circuit intégré différentiel comportant une paire différentielle avec en amont de la paire au moins un étage suiveur ayant un transistor (Ts1, Ts2) et une source de courant (SC1, SC2), comportant les étapes suivantes :
- annuler les tensions différentielles sur les entrées du circuit différentiel pendant une phase de calibration distincte de la phase d'utilisation normale,
- charger une capacité (C1, C2) par la différence des courants de sortie des branches de la paire différentielle dans cette phase,
**caractérisé en ce qu'**il comporte aussi les étapes suivantes:
- comparer la tension aux bornes de la capacité à au moins un seuil,
- garder en mémoire, pendant la phase d'utilisation normale suivant la phase de calibration, le résultat de la comparaison,
- appliquer à la source de courant (SC1, SC2) en phase d'utilisation normale une correction fonction du résultat gardé en mémoire.

2. Procédé selon la revendication 1, **caractérisé en ce que**, pendant la phase de calibration, on applique à la capacité d'abord un courant issu d'une première branche de la paire différentielle, puis un courant dans le sens inverse issu d'une deuxième branche de la paire différentielle.

3. Procédé selon la revendication 2, **caractérisé en ce qu'**on répète n fois la charge et la décharge pour accroître la tension engendrée aux bornes de la capacité par la différence des courants de sortie de la paire.

4. Procédé selon l'une des revendications 1 à 3, **caractérisé en ce que** la correction appliquée à la source de courant (SC1, SC2) de l'étage suiveur comprend la mise en parallèle avec la source de courant d'une autre source de courant de valeur fixe (SC1 a, SC2a).

5. Procédé selon l'une des revendications précédentes,
**caractérisé en ce qu'**il est prévu deux capacités (C1, C2) et **en ce que** l'une des capacités est chargée par l'un des courants de sortie pendant que l'autre est chargée par l'autre courant puis les capacités sont déchargées en croisant les branches, les capacités étant ensuite mises en série en vue de la comparaison avec le seuil.

6. circuit intégré électronique à paires différentielles comportant
- au moins deux entrées pour recevoir deux tensions (V1, V2)
- deux sorties en courant appliquées à des charges (CH1, CH2),
- au moins une paire de branches différentielles (T1, T2) reliées à ces charges et,
- en amont de la paire différentielle, au moins un étage suiveur comportant un transistor (Ts1, Ts2) et une source de courant (SC1, SC2) reliée à l'émetteur de ce transistor,
- un séquenceur pour établir une phase de calibration de tension de décalage et une phase d'utilisation du circuit après calibration,
- au moins une capacité (C1, C2) associée à la paire différentielle,
circuit **caractérisé en ce qu'**il comporte en outre:
- un ensemble de commutateurs actionnés par le séquenceur pour aiguiller les courants de sortie vers les charges pendant la phase d'utilisation et pour d'une part appliquer une tension différentielle nulle sur les entrées et d'autre part aiguiller alternativement l'un puis l'autre des courants de sortie vers la capacité pendant la phase de calibration, en alternant charge et décharge, pendant une série de créneaux fournis par le séquenceur,
- un circuit (CMP) de détection de seuils de tension aux bornes de la capacité, actionné par le séquenceur à la fin de la série de créneaux, ce circuit fournissant un signal d'état représentant le dépassement ou non dépassement d'un seuil et le signe de la tension aux bornes des capacités,
- un circuit (MEM) de maintien du signal d'état en sortie du circuit de détection, pour maintenir pendant la phase d'utilisation une valeur d'état déterminée pendant la phase de calibration,
- un circuit de modification du courant de la source de courant (SC1, SC2) de l'étage suiveur en fonction de la valeur d'état présente en sortie du circuit de maintien.

7. Circuit selon la revendication 6, **caractérisé en ce qu'**il comporte deux capacités identiques, et des commutateurs pour charger pendant une alternance l'une des capacités par l'un des courants de sortie de la paire différentielle pendant que l'autre est déchargée par l'autre courant de sortie, après quoi, pendant l'alternance suivante, c'est la première capacité qui est déchargée par le courant de la deuxième sortie pendant que la deuxième capacité est chargée par le courant de la première sortie.

8. Circuit intégré selon l'une des revendications 6 et 7, **caractérisé en ce que** la paire différentielle est une paire imbriquée comportant quatre branches différentielles partageant deux à deux une charge commune,

9. Circuit intégré selon la revendication 8, **caractérisé en ce que** la paire différentielle imbriquée fait partie d'une cellule de repliement d'un circuit à repliement dans un convertisseur analogique-numérique.

## Claims

1. Method for automatically correcting offset voltage of a differential integrated circuit comprising a differential pair with, upstream of the pair, at least one follower stage having a transistor (Ts1, Ts2) and a current source (SC1, SC2), comprising the following steps:
- cancelling the differential voltages on the inputs of the differential circuit during a calibration phase distinct from the normal usage phase,
- charging a capacitor (C1, C2) through the difference of the output currents of the branches of the differential pair in this phase,
**characterized in that** it also comprises the following steps:
- comparing the voltage at the terminals of the capacitor with at least one threshold,
- during the normal usage phase following the calibration phase, keeping the result of the comparison in memory,
- applying to the current source (SC1, SC2) in the normal usage phase a correction depending on the result kept in memory.

2. Method according to Claim 1, **characterized in that**, during the calibration phase, first of all a current from a first branch of the differential pair then a current in the reverse direction from a second branch of the differential pair is applied to the capacitor.

3. Method according to Claim 2, **characterized in that** the charge and discharge is repeated n times to increase the voltage generated at the terminals of the capacitor by the difference of the output currents of the pair.

4. Method according to one of Claims 1 to 3,
**characterized in that** the correction applied to the current source (SC1, SC2) of the follower stage comprises paralleling with the current source of another current source of fixed value (SC1a, SC2a).

5. Method according to one of the preceding claims, **characterized in that** two capacitors (C1, C2) are provided and **in that** one of the capacitors is charged by one of the output currents while the other is charged by the other current then the capacitors are discharged by crossing the branches, the capacitors then being placed in series for the purpose of the comparison with the threshold.

6. Electronic integrated circuit with differential pairs comprising
- at least two inputs to receive two voltages (V1, V2), two current outputs applied to charges (CH1, CH2),
- at least one pair of differential branches (T1, T2) connected to these charges and,
- upstream of the differential pair, at least one follower stage comprising a transistor (Ts1, Ts2) and a current source (SC1, SC2) connected to the emitter of this transistor,
- a sequencer to establish an offset voltage calibration phase and a phase of usage of the circuit after calibration,
- at least one capacitor (C1, C2) associated with the differential pair,
which circuit is **characterized in that** it also comprises:
- a set of commutators actuated by the sequencer to direct the output currents to the charges during the usage phase and in order, on the one hand, to apply a null differential voltage to the inputs and, on the other hand, to alternatively direct one and then the other of the output currents to the capacitor during the calibration phase, by alternating charge and discharge, during a series of timeslots supplied by the sequencer,
- a circuit (CMP) for detecting voltage thresholds at the terminals of the capacitor, actuated by the sequencer at the end of the series of timeslots, this circuit supplying a status signal representing the overshooting or not overshooting of a threshold and the sign of the voltage at the terminals of the capacitors,
- a circuit (MEM) for keeping the status signal at the output of the detection circuit, in order to keep, during the usage phase, a status value determined during the calibration phase,
- a circuit for modifying the current of the current source (SC1, SC2) of the follower stage depending on the status value present at the output of the retention circuit.

7. Circuit according to Claim 6, **characterized in that** it comprises two identical capacitors, and commutators for charging during an alternation one of the capacitors by one of the output currents of the differential pair while the other is discharged by the other output current, after which, during the next alternation, it is the first capacitor that is discharged by the current of the second output while the second capacitor is charged by the current of the first output.

8. Integrated circuit according to either of Claims 6 and 7, **characterized in that** the differential pair is an interleaved pair comprising four differential branches sharing a common charge two by two.

9. Integrated circuit according to Claim 8,
**characterized in that** the interleaved differential pair forms part of a folding cell of a folding circuit in an analog-digital converter.

## Patentansprüche

1. Verfahren zur automatischen Offsetspannungskorrektur einer integrierten Differentialschaltung, die ein Differenzpaar mit vor dem Paar mindestens einem Spannungsfolger mit einem Transistor (Ts1, Ts2) und einer Stromquelle (SC1, SC2) aufweist, das die folgenden Schritte enthält:
- Unterdrücken der Differenzspannungen an den Eingängen der Differentialschaltung während einer Kalibrierungsphase, die sich von der normalen Benutzungsphase unterscheidet,
- Laden eines Kondensators (C1, C2) mit der Differenz der Ausgangsströme der Zweige des Differenzpaars in dieser Phase,
**dadurch gekennzeichnet, dass** es auch die folgenden Schritte aufweist:
- Vergleichen der Spannung an den Klemmen des Kondensators mit mindestens einem Schwellwert,
- im Speicher halten des Ergebnisses des Vergleichs während der normalen Benutzungsphase nach der Kalibrierungsphase,
- Anwenden einer vom im Speicher gehaltenen Ergebnis abhängigen Korrektur an die Stromquelle (SC1, SC2) in der normalen Benutzungsphase.

2. Verfahren nach Anspruch 1, **dadurch gekennzeichnet, dass** während der Kalibrierungsphase zunächst ein von einem ersten Zweig des Differenzpaars stammender Strom und dann ein Strom in Gegenrichtung an den Kondensator angelegt wird, der von einem zweiten Zweig des Differenzpaars stammt.

3. Verfahren nach Anspruch 2, **dadurch gekennzeichnet, dass** das Laden und Entladen n-Mal wiederholt wird, um die an den Klemmen des Kondensators erzeugte Spannung durch die Differenz der Ausgangsströme des Paars zu erhöhen.

4. Verfahren nach einem der Ansprüche 1 bis 3,
**dadurch gekennzeichnet, dass** die an die Stromquelle (SC1, SC2) des Spannungsfolgers angewendete Korrektur die Parallelschaltung einer anderen Stromquelle mit festem Wert (SC1a, SC2a) mit der Stromquelle enthält.

5. Verfahren nach einem der vorhergehenden Ansprüche,
**dadurch gekennzeichnet, dass** zwei Kondensatoren (C1, C2) vorgesehen sind, und dass einer der Kondensatoren mit einem der Ausgangsströme geladen wird, während der andere mit dem anderen Strom geladen wird, dann die Kondensatoren entladen werden, indem die Zweige gekreuzt werden, wobei die Kondensatoren anschließend für den Vergleich mit dem Schwellwert in Reihe geschaltet werden.

6. Integrierte Elektronikschaltung mit Differenzpaaren, die aufweist:
- mindestens zwei Eingänge, um zwei Spannungen (V1, V2) zu empfangen,
- zwei Stromausgänge, die an Lasten (CH1, CH2) angelegt werden,
- mindestens ein Paar von Differenzzweigen (T1, T2), die mit diesen Lasten verbunden sind, und
- vor dem Differenzpaar mindestens einen Spannungsfolger, der einen Transistor (Ts1, Ts2) und eine Stromquelle (SC1, SC2) aufweist, die mit dem Emitter dieses Transistors verbunden ist,
- eine Ablaufsteuerung, um eine Offsetspannung-Kalibrierungsphase und eine Benutzungsphase der Schaltung nach Kalibrierung aufzubauen,
- mindestens einen Kondensator (C1, C2), der dem Differenzpaar zugeordnet ist,
wobei die Schaltung **dadurch gekennzeichnet ist, dass** sie weiter aufweist:
- eine Gruppe von Schaltern, die von der Ablaufsteuerung betätigt werden, um die Ausgangsströme während der Nutzungsphase zu den Lasten umzuleiten und um einerseits eine Differenzspannung Null an die Eingänge anzulegen und andererseits abwechselnd den einen und dann den anderen Ausgangsstrom während der Kalibrierungsphase zum Kondensator umzuleiten, indem Laden und Entladen abgewechselt werden, während einer Reihe von Rechteckimpulsen, die von der Ablaufsteuerung geliefert werden,
- eine Schaltung (CMP) zur Erfassung von Spannungsschwellwerten an den Klemmen des Kondensators, die von der Ablaufsteuerung am Ende der Reihe von Rechteckimpulsen betätigt wird, wobei diese Schaltung ein Zustandssignal liefert, das das Überschreiten oder Nicht-Überschreiten eines Schwellwerts und das Vorzeichen der Spannung an den Klemmen der Kondensatoren darstellt,
- eine Schaltung (MEM) zur Aufrechterhaltung des Zustandssignals am Ausgang der Erfassungsschaltung, um während der Benutzungsphase einen Zustandswert aufrechtzuerhalten, der während der Kalibrierungsphase bestimmt wird,
- eine Schaltung zur Änderung des Stroms der Stromquelle (SC1, SC2) des Spannungsfolgers in Abhängigkeit von dem Zustandswert, der am Ausgang der Halteschaltung vorhanden ist.

7. Schaltung nach Anspruch 6, **dadurch gekennzeichnet, dass** sie zwei gleiche Kondensatoren und Schalter aufweist, um während eines Wechselbetriebs einen der Kondensatoren mit einem der Ausgangsströme des Differenzpaars zu laden, während der andere vom anderen Ausgangsstrom entladen wird, wonach es während des folgenden Wechselbetriebs der erste Kondensator ist, der vom Strom des zweiten Ausgangs entladen wird, während der zweite Kondensator mit dem Strom des ersten Ausgangs geladen wird.

8. Integrierte Schaltung nach einem der Ansprüche 6 und 7, **dadurch gekennzeichnet, dass** das Differenzpaar ein verschachteltes Paar ist, das vier Differenzzweige aufweist, die sich paarweise eine gemeinsame Last teilen.

9. Integrierte Schaltung nach Anspruch 8, **dadurch gekennzeichnet, dass** das verschachtelte Differenzpaar Teil einer Faltungszelle einer Faltungsschaltung in einem Analog-Digital-Wandler ist.
